## Europäisches Patentamt
## European Patent Office
## Office européen des brevets

Veröffentlichungsnummer: **0 292 014**

**A2**

# EUROPÄISCHE PATENTANMELDUNG

Anmeldenummer: **88108161.6**

Int. Cl.4: **H01L 41/04**

Anmeldetag: **20.05.88**

Priorität: **22.05.87 DE 3717268**

Veröffentlichungstag der Anmeldung:
**23.11.88 Patentblatt 88/47**

Benannte Vertragsstaaten:
**AT DE ES FR GB IT NL SE**

Anmelder: **Siemens Aktiengesellschaft Berlin und München**
**Wittelsbacherplatz 2**
**D-8000 München 2(DE)**

Erfinder: **Wersing, Wolfram, Dipl.-Phys.**
**Weidenweg 14**
**D-8011 Kirchheim(DE)**
Erfinder: **Schnöller, Manfred, Dr. rer.nat.**
**Grete-Hoffmann-Weg 24**
**D-8041 Haimhausen(DE)**
Erfinder: **Lubitz, Karl, Dipl.-Phys.Dr.**
**Röntgenstrasse 20**
**D-8012 Ottobrunn(DE)**
Erfinder: **Mohaupt, Jutta**
**Theresienstrasse 54**
**D-8000 München 2(DE)**

**Piezoelektrischer Wandler mit sowohl auf Keramik als auch auf Kunststoffen gut haftenden Elektroden.**

Die Erfindung betrifft einen piezoelektrischen Wandler mit sowohl auf Keramik als auch auf Kunststoffen gut haftenden aus intrinsisch leitenden Kunststoff bestehenden Elektroden, sowie ein Verfahren zu seiner Herstellung. Auf der Oberfläche von piezokeramischen Bauteilen wird durch chemische oder anodische Oxidation von Monomeren eine leitende Polymerschicht erzeugt. Die Monomeren sind dabei aus der Klasse der fünfgliedrigen, Schwefel oder Stickstoff als Heteroatom enthaltenden Heterozyklen ausgewählt, oder Anilin, Azulen oder Derivate der genannten Verbindungen. Die mit den kostengünstigen Elektroden versehenen Bauteile lassen sich vorteilhaft zu sandwichartigen Wandlern mit Kunststoffzwischenschichten zusammensetzen, welche gute elektroakustische Eigenschaften aufweisen.

FIG 2

# Piezoelektrischer Wandler mit sowohl auf Keramik als auch auf Kunststoffen gut haftenden Elektroden.

Die Erfindung betrifft einen piezoelektrischen Wandler mit sowohl auf Keramik als auch auf Kunststoffen gut haftenden Elektroden, sowie ein Verfahren zu seiner Herstellung.

Ein piezoelektrischer Luft-Ultraschallwandler ist zum Beispiel aus der europäischen Patentanmeldung 0 154 706 bekannt. Dieser elektroakustische Wandler besteht aus keramischen Lamellen, die in bestimmten Abständen in zueinander parallelen Ebenen angeordnet sind. Die durch die Abstände gebildeten Zwischenräume sind dabei mit einem geeigneten formstabilen Material gefüllt.

Für dieses formstabile Material bieten sich in erster Linie Kunststoffe an, deren Eigenschaften leicht den akustischen und mechanischen Anforderungen angepaßt werden können.

Zum Aufbau einer sandwichartigen Wandlerstruktur müssen die einzelnen Keramiklamellen auf haltbare Weise miteinander bzw. mit dem die Zwischenräume füllenden Kunststoff verbunden werden, was zum Beispiel durch Verkleben erfolgen kann.

Die beim Stand der Technik üblichen Nickelektroden lassen sich leicht und billig durch chemische Abscheidung auf der Keramikoberfläche herstellen. Doch zeigt diese Art von Elektroden eine - schlechte Haftung auf Kunststoffen und läßt sich daher nur schwer mit diesen verbinden, wie es für den Aufbau einer Sandwichstruktur aber nötig ist.

Alternativ dazu verwendete Silberelektroden (Einbrennsilber) zeigen zwar eine gute Haftung auf Kunststoff, verursachen aber hohe Herstellungskosten.

Aufgabe der Erfindung ist es daher, ein preisgünstiges Elektrodenmaterial anzugeben, das einfach und gut haftend auf Keramik abgeschieden werden kann und das sich gleichzeitig mit anderen Kunststoffen gut verbinden (verkleben) läßt.

Diese Aufgabe wird durch einen piezoelektrischen Wandler der eingangs genannten Art erfindungsgemäß dadurch gelöst, daß das Elektrodenmaterial ein intrinsich leitender Kunststoff ist.

Weiterhin liegt es im Rahmen der Erfindung, daß zum Herstellen eines solchen Wandlers auf einander gegenüberliegenden Seiten eines vorzugsweise plättchenförmigen piezokeramischen Bauteils ein Monomeres des intrinsisch leitenden Kunststoffes aufgebracht und durch chemische oder anodische Oxidation polymerisiert wird, und daß anschließend das Bauteil in vorgegebener Weise weiterverarbeitet wird.

Weitere Ausgestaltungen der Erfindung ergeben sich aus den Unteransprüchen.

Das Aufbringen der Polymerelektrode auf den piezokeramischen Bauteilen durch chemische Oxidation kann durch Solvenspolymerisation oder durch eine Gasphasenreaktion erfolgen.

Bei der Solvenspolymerisation werden die keramischen Teile in Lösungen des Monomeren getaucht, damit besprüht oder anderweitig damit benetzt und anschließend mit einer Lösung des korrespondierenden Oxidationsmittels behandelt. Dadurch setzt die oxidative Polymerisation ein. Doch auch die umgekehrte Verfahrensweise ist möglich. Dabei wird zunächst eine das Oxidationsmittel enthaltende Lösung auf der Keramik aufgebracht und diese danach mit einer Lösung des Monomeren behandelt. Nach dem ersten Schritt und anschließendem eventuellem Abdampfen des Lösungsmittels kann der zweite Schritt auch in einer Gasphasenreaktion bestehen. Dazu werden die mit dem Monomeren bzw. dem Oxidationsmittel vorbehandelten Keramikteile einer das Oxidationsmittel bzw. das Monomer enthaltenden Dampfphase ausgesetzt.

Die Monomeren sind ausgewählt aus der Klasse der fünfgliederi gen, Schwefel oder Stickstoff als Heteroatom enthaltenden Heterocyclen, Anilin, Azulen oder Derivaten derselben, vorzugsweise aber Pyrrol oder Thiophen.

Oxidationsmittel sind insbesondere Peroxosäuren und deren Salze, beispielsweise Peroxodischwefelsäure und deren Salze, auch Perchlorsäure sowie deren Schwermetallsalze wie Eisenperchlorat sind geeignet. Vorzugsweise werden auch Peroxoborate oder Peroxochromate verwendet. Auch Permanganate sind geeignet, wenn diesen geringe Mengen Säure zugesetzt werden. Auch die Verwendung von Wasserstoffperoxid in Verbindung mit der Anwesenheit von Leitsalzen ist möglich. Die Lösung der Oxidationsmtitel erfolgt vorzugsweise in Wasser, gegebenenfalls in Abmischung mit organischen, mit Wasser mischbaren Lösungsmitteln oder auch in rein organischen Lösungsmitteln.

Die Oxidationsmittel können gegebenenfalls zusammen mit einem Leitsalz auf der Oberfläche der Keramikteile aufgebracht werden, wobei die Leitsalze auch als Komplexierungs- oder Dotierungsmittel bezeichnet werden. Dafür haben sich zum Beispiel organische Sulfate, Sulfonsäuren oder auch anorganische Salze wie Lithiumperchlorat, Kaliumtetrafluoroborat, Kaliumhexafluorozirkonat, Eisen(III)-Chlorid oder Hexafluorphosphate bewährt. Die Konzentration der Leitsalze ist so bemessen, daß auf drei Mol des eingesetzten Monomers oder der Gemische der Monomeren mindestens ein Mol an Leitsalz verwendet wird. Ist dieses Leitsalz beispielsweise Eisen (III) Chlorid oder Eisenperchlorat, so sind solche Verbindungen Leitsalze und gleichzeitig auch Oxidationsmittel.

Die elektrochemische Polymerisation erfolgt entweder in der Nähe einer Elektrode (Anode) oder durch Verbinden der Elektrode mit der Keramikoberfläche. Dies setzt allerdings eine leitfähige oder zumindest eine durch gegebene Dotierstoffe oder andere Hilfsmittel leitfähig gemachte Keramikoberfläche voraus. Die zur elektrochemischen Polymerisation nötigen Stromdichten liegen vorzugsweise zwischen 10 und 100 A/m².

Sämtliche Prozesse, mit Ausnahme der Gasphasenreaktionen, kön nen bereits bei Raumtemperatur durchgeführt werden.

Derartig aufgebrachte Elektroden weisen eine außerordentlich gute Haftung auf dem Keramikmaterial auf. Auch hochporöse Keramikmaterialien, die auf herkömmliche Art und Weise nur schwer mit Elektroden zu versehen sind, können so problemlos kontaktiert werden. Die Keramikoberfläche ist dabei auch in den Poren komplett mit einer Kunststoffschicht belegt. Dadurch entsteht ein außerordentlich naher und guter elektrischer bzw. mechanischer Kontakt zwischen Keramik und Kunststoff.

Zum Testen der elektrischen Eigenschaften aufgenommene Polarisations-Hysteresekurven sind identisch mit denen von als Referenz betrachteten aufgesputterten Elektroden. Dies beweist die hohe Qualität der Elektrode und zeigt, daß sich keine nichtleitenden Gebiete an der Grenzfläche zwischen Keramik und Kunststoff gebildet haben, wie es beispielsweise bei aus gebrannter Silberpaste gebildeten Elektroden der Fall ist.

Auch bei den elektromechanischen Eigenschaften der so erzeugten Bauteile zeigt sich kein Unterschied zu Bauteilen mit herkömmlichen Elektroden. Der elektromechanische Kopplungsfaktor und die Frequenzkonstante (Produkt aus Resonanzfrequenz und Querschnitt des Bauteils) sind bei Bauteilen mit Kunststoffelektroden und herkömmlichen Elektroden nahezu identisch. Der einzige Unterschied liegt in der gegenüber Metallelektroden niedrigeren Leitfähigkeit.

Anwendungen als elektromechanischer Wandler sind daher nur bei Betriebsfrequenzen bis zu 1 MHz sinnvoll. Vorteilhaft können derartige Bauteile als quasistatische elektromechanische Wandler für alle übrigen Anwendungen eingsetzt werden. Besonders vorteilhaft ist das Aufbringen der erfindungsgemäßen Kunststoffelektroden auf dünnen Keramikfolien, welche sandwichartig in mehreren Schichten zu größeren Bauteilen verarbeitet bzw. zusammengesetzt werden. Dies geschieht, um die zum Betrieb des Bauteils nötige Spannung auf das bei üblichen elektronischen Geräten verwendete Niveau von 5 bis 10 Volt zu reduzieren.

Genauso vorteilhaft können die erfindungsgemäßen Elektroden auf extrem poröser Keramik aufgebracht werden.

Die hohe optische Absorption der Kunststoffelektroden erlaubt auch einen Einsatz der Bauteile als Pyrodetektoren.

Die erfindungsgemäßen Elektroden können außerdem billig hergestellt werden und sind unempfindlich gegen Chemikalien, die Metallelektroden angreifen würden. Die hohe Elastizität der Kunststoffe sorgt außerdem für große mechanische Stabilität so erzeugter Bauteile.

Zum Aufbau von piezokeramischen Bauteilen mit sandwichartiger Struktur bieten sich mehrere Verfahrensweisen an. Die mit Kunststoffelektroden versehenen Keramikplättchen werden schichtweise, zum Beispiel durch Dazwischenlegen von Kunststoffolien verklebt. Bei der Anordnung im bestimmten Abstand übereinander können die Zwischenräume auch anderweitig mit Kunststoff aufgefüllt werden. Dazu bieten sich beispielsweise Spritzgießverfahren an oder auch das Ausfüllen der Zwischenräume mit Schaumstoff.

Im weiteren wird die Erfindung anhand von drei Ausführungsbeispielen und von zwei Figuren näher erläutert.

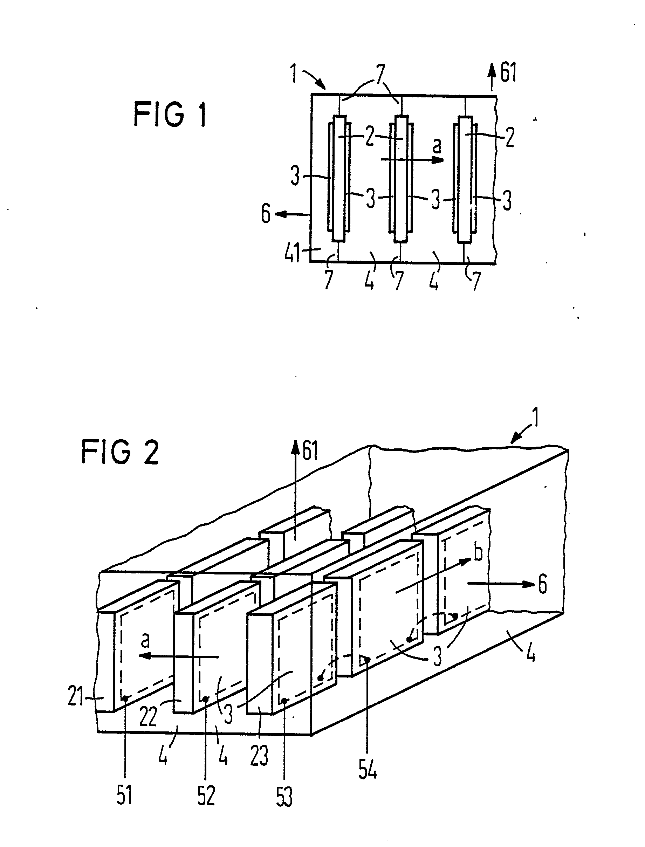

Die Figuren 1 und 2 zeigen im Schnittbild bzw. in perspektivischer Ansicht einen erfindungsgemäßen piezoelektrischen Wandler.

## Erstes Ausführungsbeispiel

Die Oberfläche eines Piezokeramikplättchens aus porösem Bleititanat Zirconat (500 μm dick) wird mit einer 10 %igen alkoholischen Lösung von Eisenperchlorat bestrichen. Nach Abdampfen des Lösungsmittels wird das Plättchen bei einer Temperatur von 150°C 30 Sekunden lang einer 10 (Volumen) % Pyrrol enthaltenden Stickstoffatmosphäre ausgesetzt. Nach wenigen Sekunden bildet sich ein dunkler Überzug aus Polypyrrol. Der unlösliche Film weist eine Leitfähigkeit von $10^{-2}$ S/cm auf.

## Zweites Beispiel:

Ein Piezokeramikplättchen von 300 μm Dicke wird mit einer wäßrigen Lösung bestrichen, die 10 Gewichtsprozent Natriumperoxidisulfat und 5 Gewichtsprozent Phenylsulfonsäure enthält. Das Lösungsmittel wird abgedampft und das so behandelte Material mit einer 10 %igen (Gew.) ethanolischen Pyrrollösung bestrichen. Es bildet sich ein homogener, fest haftender und unlöslicher Polypyrrolfilm aus, der eine spezifische Leitfähigkeit von $0,2 \cdot 10^{-1}$ S/cm aufweist.

Drittes Beispiel:

Ein Piezokeramikwerkstück von 3 mal 6 cm Fläche und 200 μm Dicke wird wie im Beispiel 2 mit Peroxidisulfat und Phenylsulfonsäure vorbehandelt. Nach Abdampfen des Wassers wird das so behandelte Werkstück in eine Lösung von 1 Gramm Pyrrol in 100 ml Acetonitril getaucht, die außerdem als Leitsalz 0,5 Gramm Phenylsulfonsäure enthält und als Anode geschaltet. Mit einer Platingegenelektrode und einem Elektrodenabstand von 3 cm wird 60 Minuten lang elektrolysiert. Die Stromdichte beträgt dabei 100 A/m². Danach ist ein schwarzer Polypyrrolüberzug auf der Keramik entstanden, der eine Leitfähigkeit von $10^{-1}$ S/cm aufweist.

Die Figur 1 zeigt im Schnittbild einen piezoelektrischen Wandler 1 mit Sandwichstruktur. Die mit erfindungsgemäßen Kunststoffelektroden 3 versehene Keramikplättchen 2 von beispielsweise 200 μm Dicke werden zunächst in vorgegebener Weise mit elektrischen Anschlüssen versehen (in der Figur nicht dargestellt). Beginnend mit einer Polyethylenfolie 41 wird in Richtung a ein Stapel aufgebaut, der immer abwechselnd aus Schichten von Polyethylenfolie 4 und Piezokeramikplättchen 2 besteht, und dessen Schichten heiß verklebt sind. Zwischen den Kunststoffelektroden 3 und den thermoplastischen Polyethylenfolien (4, 41) entsteht dabei eine feste und dauerhafte Verbindung. Mit den Strichen 7 ist angedeutet, daß die Folien 4, 41 im Stapel die Keramikplättchen 2 überlappen und an den Grenzlinien 7 mit sich selbst bzw. der nächsten benachbarten Folie verklebt sind. Die Keramikteile sind somit vollständig von Polyethylen eingeschlossen.

Je nach elektrischer Schaltung der Elektroden 3 und abhängig von der Polarität der Piezokeramiken 2 können bevorzugte Schallabstrahl bzw. Empfangsrichtungen 6 bzw. 61 erreicht werden.

Figur 2 zeigt einen größeren Ausschnitt eines erfindungsgemäßen Wandlers 1 in perspektivischer Ansicht. Zusätzlich zum Aufbau eines Stapels in Richtung a können mehrere solcher Stapel in Richtung b hintereinander angeordnet sein. Mit 51, 52 und 53 ist die elektrische Kontaktierung der Keramikplättchen 21, 22 und 23 bzw. deren Elektroden 3 bezeichnet. 54 zeigt eine mögliche elektrische Kontaktierung zwischen zwei Keramikplättchen in verschiedenen Stapeln. Die hinteren Stapel können jedoch auch direkt wie im vorderen Stapel kontaktiert sein.

Weitere Ausgestaltungen dieses Wandlers werden je nach Anwendung dem Stand der Technik entnommen.

Ansprüche

1. Piezoelektrische Wandler mit sowohl auf Keramik, als auch auf Kunststoffen gut haftenden Elektroden, **dadurch gekennzeichnet,** daß das Elektrodenmaterial ein intrinsisch leitender Kunststoff ist.

2. Verfahren zum Herstellen eines piezoelektrischen Wandlers nach Anspruch 1, **dadurch gekennzeichnet,** daß auf einander gegenüberliegenden Seiten eines vorzugsweise plättchenförmigen piezokeramischen Bauteiles ein Monomeres des intrinsisch leitenden Kunststoffes aufgebracht und durch chemische oder anodische Oxidation polymerisiert wird, und daß anschließend das Bauteil in vorgegebener Weise weiterverarbeitet wird.

3. Verfahren nach Anspruch 2, **dadurch gekennzeichnet,** daß das Monomere aus der Klasse der fünfgliedrigen Schwefel oder Stickstoff als Heteroatom enthaltenden Heterocyclen, Anilin, Azulen oder ein Derivat dieser Verbindungen ist.

4. Verfahren nach einem der Ansprüche 2 oder 3, **dadurch gekennzeichnet,** daß die anodische Oxidation des Monomeren in Gegenwart eines Leitsalzes erfolgt.

5. Verfahren nach mindestens einem der Ansprüche 2 bis 4, **dadurch gekennzeich net,** daß mehrere piezokeramische Bauteile zu einer sandwichartigen Struktur zusammengefügt werden, wobei die Bauteile schichtweise in einem bestimmten Abstand übereinander angeordnet werden und die Zwischenräume mit einem Kunststoff aufgefüllt werden.

6. Verfahren nach Anspruch 5, **dadurch gekennzeichnet,** daß die Zwischenräume durch Verkleben der Bauteile mit geeigneten Kunststoffolien aufgefüllt werden.

7. Verfahren nach Anspruch 5, **dadurch gekennzeichnet,** daß die Zwischenräume mittels eines Spritzgießverfahrens aufgefüllt werden.

8. Verfahren nach Anspruch 5, **dadurch gekennzeichnet,** daß die Zwischenräume mit Schaumstoff gefüllt werden.

FIG 1

FIG 2